# EUROPEAN PATENT APPLICATION

(11) **EP 4 764 862 A1**
(43) Date of publication of application: **24.06.2026**
(21) Application number: 25822412.0
(22) Date of filing: 28.05.2025
(51) Int. Cl.: G06F 11/07, G06F 11/30, G01R 31/396, G01R 31/385, G06F 3/06

(54) **BATTERY MANAGEMENT DEVICE AND METHOD THEREOF**

(30) Priority: 12.06.2024 KR 20240076471
(71) Applicant: LG Energy Solution, Ltd., Seoul 07335 (KR)
(72) Inventor: KIM, Ji Yong, Daejeon 34122 (KR)
(74) Representative: Plasseraud IP
(86) International application number: PCT/KR2025/007227
(87) International publication number: WO 2025/258894

(57) **Abstract**

A battery management device according to an embodiment of the present disclosure may include a memory configured to store at least one instruction and one or more processors configured to execute the at least one instruction, and the one or more processors may obtain measured values by measuring electrical characteristics of battery cells, obtain subtracted values by subtracting a representative value representing the measured values from the measured values, determine a range in which data compression is to be performed based on the subtracted values, generate a first partial stream according to a subtracted value of any one of the battery cells among the subtracted values or generate a second partial stream according to a measured value corresponding to the subtracted value, based on whether the subtracted value is included in the range, and generate a data stream indicating the measured values based on at least one of the first partial stream, the second partial stream, or any combination thereof.

## Description

### TECHNICAL FIELD

### Cross-reference to Related Applications

This application claims priority from Korean Patent Application No. 10-2024-0076471, filed on June 12, 2024, the disclosure of which is incorporated by reference herein.

### Technical Field

Embodiments disclosed herein relate to a battery management device and a method thereof.

### BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. In recent years, the lithium ion batteries have expanded their range of use to power sources for electric vehicles, making the batteries attract attention as a next-generation energy storage medium.

With the increased use of high-capacity, high-output batteries in various industrial fields due to the 4th industrial revolution, the importance of battery monitoring and analysis is also increasing. Along with this, both the collection speed and collection amount of battery data required for battery monitoring and analysis are rapidly increasing. As a result, the resources required to store and transmit the collected battery data also tend to increase. In order to address this issue, there is a growing demand for the development of battery data compression techniques that take into account the characteristics of battery data. Advancements in battery compression techniques may lead not only to a reduction in the cost of storing and transmitting battery data but also to an improvement in system performance.

### DISCLOSURE OF THE INVENTION

### TECHNICAL PROBLEM

Embodiments disclosed herein provide a battery management device and a method thereof for reducing resources consumed for storing and transmitting battery data by compressing the battery data.

Embodiments disclosed herein provide a battery management device and a method thereof for improving the performance of a system by compressing battery data.

Embodiments disclosed herein provide a battery management device and a method thereof for reducing resources consumed for compressing battery data by flexibly changing a compression range of the battery data.

Embodiments disclosed herein provide a battery management device and a method thereof for reducing bandwidth required for transmission by compressing battery data and transmitting the compressed battery data.

Embodiments disclosed herein provide a battery management device and a method thereof for reducing data loss in compressing and restoring battery data by losslessly compressing the battery data.

Embodiments disclosed herein provide a battery management device and a method thereof for securing visibility into compressed battery data by compressing the battery data while maintaining a trend of the battery data.

Embodiments disclosed herein provide a battery management device and a method thereof for improving the ease of analysis of compressed battery data by compressing the battery data while maintaining a trend of the battery data.

The technical problems of the present disclosure are not limited to those mentioned above, and other objectives not mentioned will be clearly understood by those skilled in the art from the following descriptions.

### TECHNICAL SOLUTION

A battery management device according to an embodiment of the present disclosure may include a memory configured to store at least one instruction, and one or more processors configured to execute the at least one instruction.

According to an embodiment, the one or more processors may obtain measured values by measuring electrical characteristics of battery cells, obtain subtracted values by subtracting a representative value representing the measured values from the measured values, determine a range in which data compression is to be performed based on the subtracted values, generate a first partial stream according to a subtracted value of any one of the battery cells among the subtracted values or generate a second partial stream according to a measured value corresponding to the subtracted value, based on whether the subtracted value is included in the range, and generate a data stream indicating the measured values based on at least one of the first partial stream, the second partial stream, or any combination thereof.

According to an embodiment, the one or more processors may identify the representative value as a median value.

According to an embodiment, the one or more processors may generate a header of the data stream to include at least one of a stream indicating the range, a stream indicating the representative value, or any combination thereof.

According to an embodiment, the one or more processors, when the subtracted value of the one battery cell among the subtracted values is included in the range, may generate the first partial stream to include at least one of a stream indicating a fact that the subtracted value of the one battery cell is included in the range, a stream indicating the subtracted value of the one battery cell, or any combination thereof.

According to an embodiment, the one or more processors, when a subtracted value of any other one of the battery cells among the subtracted values is not included in the range, may generate the second partial stream to include at least one of a stream indicating a fact that the subtracted value of the other battery cell is not included in the range, a stream indicating a measured value of the other battery cell, or any combination thereof.

According to an embodiment, the one or more processors, when the battery cells corresponding to the subtracted values included in the range are consecutive according to a specified order of the battery cells, may generate a header of the first partial stream to include a stream indicating a fact that the battery cells corresponding to the subtracted values included in the range are consecutive, and a stream indicating the number of the consecutive battery cells and generate the first partial stream to sequentially represent subtracted values of the consecutive battery cells according to the specified order.

According to an embodiment, in order to determine the range from among preset ranges in which data compression is to be performed, the one or more processors may identify, according to any one of the ranges, a ratio of the number of battery cells corresponding to subtracted values not included in the one range of the ranges to the total number of the battery cells and determine, as the range, the narrowest range among the ranges having the ratio less than a specified ratio.

According to an embodiment, the one or more processors may determine the widest range among the preset ranges as the range when there is no range having a ratio less than the specified ratio among the ranges.

According to an embodiment, the measured values obtained by measuring electrical characteristics may include values obtained by measuring voltages of the battery cells.

According to other embodiments disclosed in the present disclosure, a method of managing a battery may include obtaining measured values by measuring electrical characteristics of battery cells, obtaining subtracted values by subtracting a representative value representing the measured values from the measured values, determining a range in which data compression is to be performed based on the subtracted values, generating a first partial stream according to a subtracted value of any one of the battery cells among the subtracted values or generating a second partial stream according to a measured value corresponding to the subtracted value, based on whether the subtracted value is included in the range, and generating a data stream indicating the measured values based on at least one of the first partial stream, the second partial stream, or any combination thereof.

According to an embodiment, the obtaining of the subtracted values by subtracting the representative value representing the measured values from the measured values may include identifying the representative value as a median value.

According to an embodiment, the generating of the data stream indicating the measured values based on at least one of the first partial stream, the second partial stream, or any combination thereof may include generating a header of the data stream to include at least one of a stream indicating the range, a stream indicating the representative value, or any combination thereof.

According to an embodiment, the generating of the first partial stream according to a subtracted value of any one of the battery cells among the subtracted values or generating of the second partial stream according to a measured value corresponding to the subtracted value, based on whether the subtracted value is included in the range may include generating, when the subtracted value of the one battery cell among the subtracted values is included in the range, the first partial stream to include at least one of a stream indicating a fact that the subtracted value of the one battery cell is included in the range, a stream indicating the subtracted value of the one battery cell, or any combination thereof.

According to an embodiment, the generating of the first partial stream according to a subtracted value of any one of the battery cells among the subtracted values or generating of the second partial stream according to a measured value corresponding to the subtracted value, based on whether the subtracted value is included in the range may include generating, when a subtracted value of any other one of the battery cells among the subtracted values is not included in the range, the second partial stream to include at least one of a stream indicating a fact that the subtracted value of the other battery cell is not included in the range, a stream indicating a measured value of the other battery cell, or any combination thereof.

According to an embodiment, the generating of the first partial stream according to a subtracted value of any one of the battery cells among the subtracted values or generating of the second partial stream according to a measured value corresponding to the subtracted value, based on whether the subtracted value is included in the range may include, when the battery cells corresponding to the subtracted values included in the range are consecutive according to a specified order of the battery cells, generating a header of the first partial stream to include a stream indicating a fact that the battery cells corresponding to the subtracted values included in the range are consecutive, and a stream indicating the number of the consecutive battery cells and generating the first partial stream to sequentially represent subtracted values of the consecutive battery cells according to the specified order.

According to an embodiment, the determining of the range in which data compression is to be performed based on the subtracted values may include, in order to determine the range from among preset ranges in which data compression is to be performed, identifying, according to any one of the ranges, a ratio of the number of battery cells corresponding to subtracted values not included in the one range of the ranges to the total number of the battery cells and determining, as the range, the narrowest range among the ranges having the ratio less than a specified ratio.

According to an embodiment, the determining of the range in which data compression is to be performed based on the subtracted values may include determining the widest range among the preset ranges as the range when there is no range having a ratio less than the specified ratio among the ranges.

According to an embodiment, the measured values obtained by measuring electrical characteristics may include values obtained by measuring voltages of the battery cells.

### ADVANTAGEOUS EFFECTS

The present technology can reduce resources consumed for storing and transmitting battery data by compressing the battery data.

In addition, the present technology can improve performance of a system by compressing battery data.

In addition, the present technology can reduce resources consumed for compressing battery data by flexibly changing a compression range of the battery data.

In addition, the present technology can reduce bandwidth required for transmission by compressing battery data and transmitting the compressed battery data.

In addition, the present technology can reduce data loss in compressing and restoring battery data by losslessly compressing the battery data.

In addition, the present technology can secure visibility into compressed battery data by compressing the battery data while maintaining a trend of the battery data.

In addition, the present technology can improve the ease of analysis of compressed battery data by compressing the battery data while maintaining a trend of the battery data.

Besides, various effects may be provided that are directly or indirectly identified through the present disclosure.

### BRIEF DESCRIPTION OF THE DRAWINGS

FIG. 1 is a block diagram illustrating a battery pack in a battery management device and a battery management method according to an embodiment of the present disclosure.
FIG. 2 is a block diagram illustrating a configuration of a battery management device according to an embodiment of the present disclosure.
FIG. 3 illustrates the structure of a data stream obtained by performing data compression in a battery management device and a battery management method according to an embodiment of the present disclosure.
FIG. 4 illustrates examples of battery data and a data stream obtained by compressing the battery data in a battery management device and a battery management method according to an embodiment of the present disclosure.
FIG. 5 illustrates examples of compression rates according to examples of a battery management device and a battery management method according to an embodiment of the present disclosure.
FIG. 6 illustrates an example of a flow of operations of a battery management device that generates a data stream through a first partial stream and a second partial stream, in the battery management device and a battery management method according to an embodiment of the present disclosure.
FIG. 7 illustrates an example of a flow of operations of a battery management device that generates a data stream through at least one of a first partial stream, a second partial stream, or any combination thereof, in the battery management device and a battery management method according to an embodiment of the present disclosure.
FIG. 8 is a block diagram illustrating a hardware configuration of a computing system for performing a battery management method in a battery management device and the battery management method according to an embodiment of the present disclosure.

### MODE FOR CARRYING OUT THE INVENTION

Hereinafter, some embodiments disclosed herein are described with reference to the accompanying drawings of various embodiments of the present disclosure. However, this is not intended to limit the present technology to the specific embodiments, and it is to be construed to include various modifications, equivalents, and/or alternatives of embodiments of the present technology.

In adding reference numerals to the components of each drawing, it should be noted that the same components are given the same reference numerals as much as possible even though they are shown on different drawings. In addition, in describing various embodiments disclosed herein, when a detailed description of a related known configuration or function is determined to hinder understanding of the embodiments of the present invention, the detailed description thereof is omitted. It is to be understood that a singular form of a noun corresponding to an item may include one or more of the things, unless the relevant context clearly indicates otherwise.

In addition, in describing a component of the embodiments of the present disclosure, terms such as first, second, A, B, (a), (b), etc. may be used. These terms are only for distinguishing the component from other components, and the essence, sequence, or order of the component may not be limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

In addition, in the present disclosure, in order to determine whether a specific condition is satisfied or fulfilled, expressions "more than" or "less than" may be used, but this is only a description for expressing an example and does not exclude descriptions of "equal to or more than" or "less than or equal to." A condition described as "equal to or more than" may be replaced with "more than, " a condition described as "less than or equal to" may be replaced with "less than, " and a condition described as "equal to or more than and less than" may be replaced with "more than and less than or equal to." In addition, hereinafter, "A to B" mean at least one of the elements from A (inclusive of A) to B (inclusive of B).

In the present disclosure, each of phrases such as "A or B," "at least one of A and B," "at least one of A or B," "A, B or C, " "at least one of A, B and C, " or "at least one of A, B, or C," may include any one of the items listed in the phrase, or all possible combinations of the phrases.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the described components may include a single entity or multiple entities, and some of the plurality of entities may be disposed separately from other components. According to various embodiments, one or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

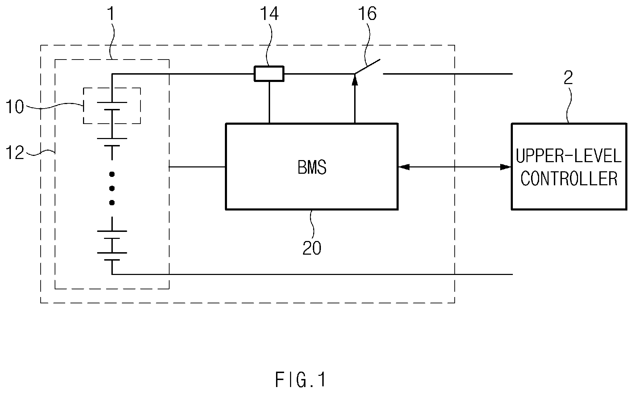

Hereinafter, embodiments of the present disclosure will be described in detail with reference to FIGS. 1 to 8.

FIG. 1 is a block diagram illustrating a battery pack in a battery management device and a battery management method according to an embodiment of the present disclosure.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). For this purpose, the battery unit 12 may be electrically connected to the target device. Here, the target device may include an electrical, electronic, or mechanical device that operates by receiving power from the battery pack 1. For example, the target device may be an electric vehicle (EV), but is not limited thereto.

According to an embodiment, the battery unit 12 may include at least one battery cell 10 that is rechargeable and dischargeable. Here, the battery cell 10 may be a basic unit of a battery cell that may be used by being charged and discharged with electric energy. For example, the battery cell 10 may be a lithium ion (Li-ion) battery, a lithium ion (Li-ion) polymer battery, a nickel cadmium (Ni-Cd) battery, a nickel hydrogen (Ni-MH) battery, or the like, and may not be limited thereto.

According to an embodiment, a plurality of battery units 12 may be connected in series or in parallel. For example, the battery unit 12 may be a battery module, a battery bank, or a collection of battery cells (cell-to-pack structure).

According to an embodiment, the sensor unit 14 may acquire information related to the battery unit 12. According to an embodiment, the sensor unit 14 may acquire values (or information) related to the state of each of the battery units 12 or battery cells 10. In an embodiment, the state-related values may include one or more values for voltage, current, resistance, state of charge (SOC), state of health (SOH), or temperature of the battery cell, or a combination thereof.

According to an embodiment, the sensor unit 14 may provide information on each of the plurality of battery units 12 to the battery management system 20.

According to an embodiment, the switching unit 16 may include a device for controlling the current flow for charging or discharging the battery unit 12. For example, the switching unit 16 may include at least one relay and/or magnetic contactor, depending on the specifications of the battery pack 1.

According to an embodiment, the battery management system (BMS) 20 may control or manage the battery pack 1 to prevent overcharge and over-discharge by monitoring the voltage, current, temperature, and the like of the battery pack 1. For example, the battery management system 20 may be an interface for receiving values obtained by measuring the above-mentioned various parameters, and may include a plurality of terminals, a circuit connected to the terminals to process input values, or the like. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of the relay, the contactor, or the like.

According to an embodiment, the operation of the battery management system 20 may be performed by the BMS (battery management system) in a vehicle, as well as by various devices such as a server, a cloud, a charger, a discharger, or the like.

An upper-level controller 2 may transmit a control signal for the plurality of battery units 12 to the battery management system 20. Accordingly, the operation of the battery management system 20 may be controlled based on the signal received from the upper controller 2.

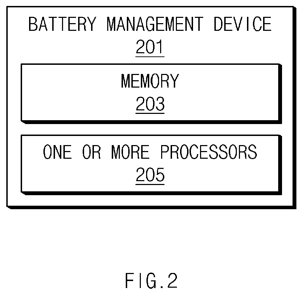

According to an embodiment, the battery management system 20 may include a battery management device 201 in FIG. 2. In another embodiment, the battery management system 20 may be a system different than the battery management device 201 in FIG. 2. That is, the battery management device 201 in FIG. 2 may be included in the battery pack 1 or may be configured as another device external to the battery pack 1. For convenience of explanation, the following description assumes that the battery management device 201 is constructed as another device external to the battery pack 1. In addition, the operation of the battery management device 201 below may be performed by a battery management system (BMS) in the vehicle, as well as by various devices such as a server, a cloud, a charger, a discharger, or the like.

FIG. 2 is a block diagram showing a configuration of a battery management device according to an embodiment of the present disclosure.

Referring to FIG. 2, the memory 203 may store at least one instruction. The one or more processors 205 may execute at least one instruction.

According to an embodiment, the one or more processors 205 may obtain measured values (e.g., voltage values of battery cells) obtained by measuring electrical characteristics of battery cells.

According to an embodiment, the one or more processors 205 may transmit measured values to another device. For example, the one or more processors 205 may transmit the measured values to a cloud or to a device different from the battery management device (e.g., an in-vehicle high performance computer (HPC)). In this way, when transmitting the measured values to another device, the one or more processors 205 may process the measured values to reduce resources required for transmission.

A ratio of the number of bits required to generate a data stream based on processed measured values to the number of bits required to generate a data stream based on unprocessed measured values may be indicated as a compression rate. As the number of bits required to generate the data stream based on processed measured values decreases, the compression rate may increase.

According to an embodiment, the one or more processors 205 may identify a representative value (e.g., a median value or an average value) representing the measured values based on the measured values. According to an embodiment, the one or more processors 205 may obtain subtracted values by subtracting the representative value from the measured values. The median value may indicate a value located in the middle when the collected measured values are sorted in numerical size. The average value may indicate a value obtained by dividing the sum of all the collected measured values by the number of the measured values.

The number of bits required to generate a data stream based on subtracted values obtained by subtracting the representative value from the measured values may be smaller than the number of bits required to generate a data stream based on the measured values. This is because the subtracted values may contain positive and negative numbers, whereas the measured values contain only positive or negative numbers.

For example, when a first measured value is 3199, a second measured value is 3165, and a median value of the measured values is 3182, a first subtracted value corresponding to the first measured value (e.g., 3199) may be +17, and the second subtracted value corresponding to the second measured value (e.g., 3165) may be -17. The number of bits indicating a binary value (e.g., 110001111111) obtained by converting the first measured value (e.g., 3199) into a binary number may be at least 12. The number of bits indicating a binary value (e.g., 110001101110) obtained by converting the second measured value (e.g., 3165) into a binary number may be at least 12. The number of bits indicating a binary value (e.g., +10001) obtained by converting the first subtracted value (e.g., +17) into a binary number may be at least 6. The number of bits indicating a binary value (e.g., -10001) obtained by converting the second subtracted value (e.g., -17) into a binary number may be at least 6. Therefore, the number of bits required to generate a data stream based on the subtracted values may be less than the number of bits required to generate a data stream based on the measured values.

However, the number of bits required to generate a data stream based on the subtracted value for all data cells may be smaller than the number of bits required to generate a data stream based on the subtracted values for specific battery cells and generate a data stream based on the measured values for other battery cells. This is because when the subtracted value of a specific battery cell, relative to the median value, exceeds or falls below a specified value, the number of bits required to generate the data stream may actually increase.

For example, when a first measured value is 3199, a second measured value is 3165, a third measured value is 3182, and a fourth measured value is 4000, a first subtracted value corresponding to the first measured value (e.g., 3199) may be +17, a second subtracted value corresponding to the second measured value (e.g., 3165) may be -17, a third subtracted value corresponding to the third measured value (e.g., 3182) may be 0, and a fourth subtracted value corresponding to the fourth measured value (e.g., 4000) may be 818.

The number of bits indicating a binary value (e.g., +10001) obtained by converting the first subtracted value (e.g., +17) into a binary number may be at least 6. The number of bits indicating a binary value (e.g., -10001) obtained by converting the second subtracted value (e.g., - 17) into a binary number may be at least 6. The number of bits indicating a binary value (e.g., -10001) obtained by converting the third subtracted value (e.g., 0) into a binary number may be at least 1. The number of bits indicating a binary value (e.g., +1100110010) obtained by converting the fourth subtracted value (e.g., 818) into a binary number may be at least 11.

When the fourth subtracted value is taken into account, the first subtracted value, the second subtracted value, and the third subtracted value may also have to be represented by 11 bits each. For example, the first subtracted value (e.g., +10001) may be represented as +0000010001. Therefore, to represent all of the first to fourth subtracted values, 44 bits may be required.

In contrast, when the first to third subtracted values generate the data stream based on the subtracted values, and the fourth measured value generates the data stream based on the measured values, the number of bits required may be 30, which may be less than 44 bits.

This is because the first to third subtracted values may be each represented using 6 bits, totaling 18 bits, and the fourth measured value (e.g., 4000) may be represented by 12 bits (e.g., 111110100000).

Since the number of bits required to generate the data stream based on the subtracted values obtained by subtracting the representative value from the measured values may be smaller than the number of bits required to generate the data stream based on the measured values, in order to increase the efficiency of data compression, the one or more processors 205 may perform data compression depending on a range in which data compression is to be performed.

In other words, according to an embodiment, when, among the subtracted values, a subtracted value of any one of the battery cells is included in the range, the one or more processors 205 may generate a first partial stream based on the subtracted value of the battery cell, and when, among the subtracted values, a subtracted value of another of the battery cells is not included in the range, the one or more processors 205 may generate a second partial stream based on a measured value of the battery cell. The one or more processors 205 may generate the data stream based on at least one of the first partial stream, the second partial stream, or any combination thereof.

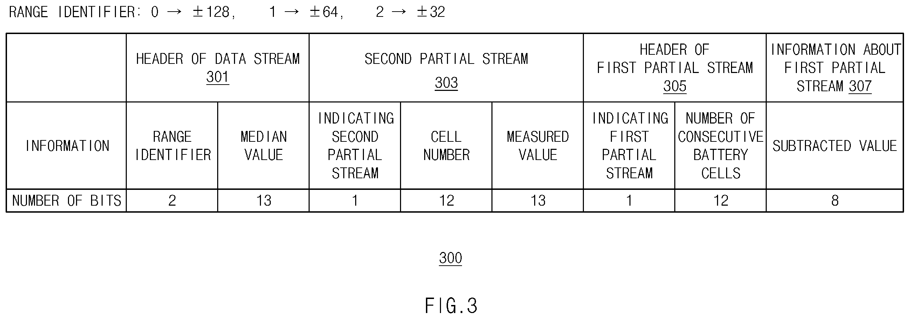

The content of generating the first partial stream and the second partial stream and generating the data stream through a combination thereof will be described below with reference to FIG. 3.

FIG. 3 illustrates the structure of a data stream obtained by performing data compression in a battery management device and a battery management method according to an embodiment of the present disclosure.

Referring to FIG. 3, a table 300 may indicate a structure of the data stream. The data stream may consist of at least one of a first partial stream, a second partial stream 303, or any combination thereof, and a header 301 of the data stream. The first partial stream may include a header 305 of the first partial stream and first partial stream information 307.

According to an embodiment, the first partial stream may indicate a stream generated according to a subtracted value of a battery cell when the subtracted value is within a range in which data compression is to be performed. The second partial stream 303 may indicate a stream generated according to a measured value when the subtracted value of the battery cell is not within the range in which data compression is to be performed.

According to an embodiment, the header 301 of the data stream may include at least one of a stream represented by a first number of bits (e.g., about 2) and indicating the range in which data compression is to be performed, a stream represented by a second number of bits (e.g., about 13) and indicating a median value of measured values of battery cells, or any combination thereof.

According to an embodiment, the range in which data compression is to be performed may include any one of preset ranges in which data compression is to be performed (e.g., a first range, a second range, and a third range). For example, the first range may indicate a range from -128 to +128. The second range may indicate a range from -64 to +64. The third range may indicate a range from -32 to +32. According to an embodiment, the range in which data compression is to be performed may be indicated by an identifier. For example, an identifier of the first range may include 0. For example, an identifier of the second range may include 1. For example, an identifier of the third range may include 2.

According to an embodiment, the header 305 of the first partial stream may include a stream represented by a third number of bits (e.g., about 1) and indicating the first partial stream. In other words, the header 305 of the first partial stream may indicate that the first partial stream generated according to the subtracted value of the battery cell included in the range in which data compression is to be performed will be presented. For example, a stream may be generated with a value of 1 when the subtracted value of the battery cell is within the range, and a stream may be generated with a value of 0 when the subtracted value of the battery cell is not within the range.

According to an embodiment, the header 305 of the first partial stream may include a stream represented by a fourth number of bits (e.g., about 12) and indicating the number of consecutive battery cells corresponding to subtracted values that are included in the range in which data compression is to be performed. For example, the number of consecutive battery cells each corresponding to a subtracted value that is included in the range in which data compression is to be performed may include the number of consecutive battery cells whose subtracted values are included in the range in which data compression is to be performed, when the battery cells are arranged in a specified order (e.g., in the order of battery cell numbers).

According to an embodiment, the first partial stream information 307 may include a stream composed of the fifth number of bits (e.g., about 8) and indicating the subtracted value of the battery cell. The first partial stream information 307 may represent the number of subtracted values corresponding to the number of consecutive battery cells appearing in the header 305 of the first partial stream. Each of the subtracted values may be composed of the fifth number of bits.

According to an embodiment, the second partial stream 303 may include a stream composed of a sixth number of bits (e.g., about 1) and indicating the second partial stream. In other words, a stream indicating the second partial stream may indicate that a second partial stream generated according to a measured value of a battery cell corresponding to a subtracted value that is not included in the range in which data compression is to be performed will be presented.

According to an embodiment, the second partial stream 303 may include a stream composed of a seventh number of bits (e.g., about 12) and indicating the number of battery cells.

According to an embodiment, the second partial stream 303 may include a stream composed of an eighth number of bits (e.g., about 13) and indicating measured values of battery cells.

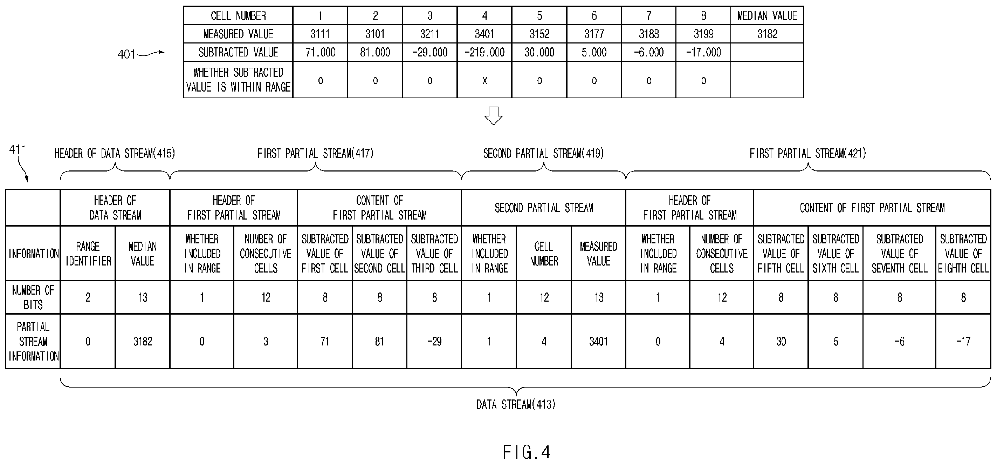

FIG. 4 illustrates examples of battery data and a data stream obtained by compressing the battery data in a battery management device and a battery management method according to an embodiment of the present disclosure.

Referring to FIG. 4, a first table 401 may indicate example data indicating measured values of battery cells, subtracted values, and whether the subtracted value is included in a range in which data compression is to be performed. The range in which data compression is to be performed in the first table 401 may be from -128 to 128.

A second table 411 may indicate the structure and content of an example data stream generated by compressing the example data of the first table 401.

According to an embodiment, the first table 401 may indicate that a median value of a first cell having a cell number of 1 to an eighth cell having a cell number of 8 is 3182. The first table 401 may indicate a measured value of the first cell (e.g., 3111), a subtracted value of the first cell (e.g., 71), the fact that the subtracted value of the first cell is within the range, a measured value of a second cell (e.g., 3101), a subtracted value of the second cell (e.g., 81), the fact that the subtracted value of the second cell is within the range, a measured value of a third cell (e.g., 3211), a subtracted value of the third cell (e.g., - 29), the fact that the subtracted value of the third cell is within the range, a measured value of a fourth cell (e.g., 3401), a subtracted value of the fourth cell (e.g., -219), the fact that the subtracted value of the fourth cell is out of the range, a measured value of a fifth cell (e.g., 3152), a subtracted value of the fifth cell (e.g., 30), the fact that the subtracted value of the fifth cell is within the range, a measured value of a sixth cell (e.g., 3177), a subtracted value of the sixth cell (e.g., 5), the fact that the subtracted value of the sixth cell is within the range, a measured value of a seventh cell (e.g., 3188), a subtracted value of the seventh cell (e.g., -6), the fact that the subtracted value of the seventh cell is within the range, a measured value of the eighth cell (e.g., 3199), a subtracted value of the eighth cell (e.g., -17), the fact that the subtracted value of the eighth cell is within the range.

According to an embodiment, the second table 411 may indicate a structure of a data stream 413 obtained by compressing example data. The data stream 413 may be composed of a header 415 of the data stream, a first partial stream 417, a second partial stream 419, and a first partial stream 421.

According to an embodiment, the header 415 of the data stream may include a stream represented by a first number of bits (e.g., about 2) and indicating the range in which data compression is to be performed. A range identifier may indicate a determined range among preset ranges in which data compression is to be performed. For example, a range with a range identifier of 0 may refer to a range from -128 to +128. For example, a range with a range identifier of 1 may refer to a range from -64 to +64. For example, a range with a range identifier of 2 may refer to a range from -32 to +32. Since the range in which data compression is to be performed in the example data is determined to be from -128 to 128, the range identifier included in the header 415 of the data stream may indicate 0.

According to an embodiment, the header 415 of the data stream may include a stream represented by a second number of bits (e.g., about 13) and indicating a median value (e.g., 3182) of the measured values of the battery cells.

According to an embodiment, the first partial stream 417 may include a header of the first partial stream and the content of the first partial stream. The header of the first partial stream may include a stream represented by a third number of bits (e.g., about 1) and indicating a fact that, when a subtracted value of any one of the battery cells is within the range among the subtracted values, the subtracted value of the one battery cell is included in the range.

According to an embodiment, the header of the first partial stream may include a stream represented by a fourth number of bits (e.g., about 12) and indicating the number (e.g., about three) of consecutive battery cells corresponding to subtracted values that are included in the range in which data compression is to be performed. In other words, the header of the first partial stream may include a stream indicating that, when battery cells corresponding to subtracted values included in the range are consecutive according to the specified order of the battery cells, the battery cells corresponding to subtracted values included in the range are consecutive. For example, each of the first cell, the second cell, and the third cell may correspond to a subtracted value included in the range in which data compression is to be performed. Therefore, the header of the first partial stream may include a stream indicating that battery cells corresponding to the subtracted values included in the range are consecutive and indicating the number of consecutive battery cells.

According to an embodiment, the content of the first partial stream may indicate subtracted values of battery cells that are sequentially represented in a specified order (e.g., 71, which is a subtracted value of the first cell, 81, which is a subtracted value of the second cell, and -29, which is a subtracted value of the third cell).

According to an embodiment, the second partial stream 419 may indicate that a second partial stream, which is composed of a sixth number of bits (e.g., about 1) and generated according to a measured value of the battery cell corresponding to a subtracted value that is not included in the range in which data compression is to be performed, will be presented.

According to an embodiment, the second partial stream 419 may include a stream composed of a seventh number of bits (e.g., about 12) and indicating a battery cell number (e.g., number 4).

According to an embodiment, a stream composed of an eighth number of bits (e.g., about 13) and indicating a measured value of a battery cell (e.g., 3401) may be included.

According to an embodiment, the first partial stream 421 may include a header of the first partial stream and the content of the first partial stream, such as the first partial stream 417. The content of the header of the first partial stream 421 may refer to the content of the header of the first partial stream 417.

For example, each of the fifth cell, the sixth cell, the seventh cell, and the eighth cell may correspond to a subtracted value included in the range in which data compression is to be performed. Therefore, the header of the first partial stream 421 may include a stream indicating that battery cells corresponding to the subtracted values included in the range are consecutive.

According to an embodiment, the header of the first partial stream may include a stream represented by a fourth number of bits (e.g., about 12) and indicating the number (e.g., about four) of consecutive battery cells corresponding to subtracted values that are included in the range in which data compression is to be performed.

According to an embodiment, the content of the first partial stream may indicate subtracted values of battery cells that are sequentially represented in a specified order (e.g., 30, which is a subtracted value of a fifth battery cell, 5, which is a subtracted value of a sixth battery cell, -6, which is a subtracted value of a seventh battery cell, and -17, which is a subtracted value of an eighth battery cell).

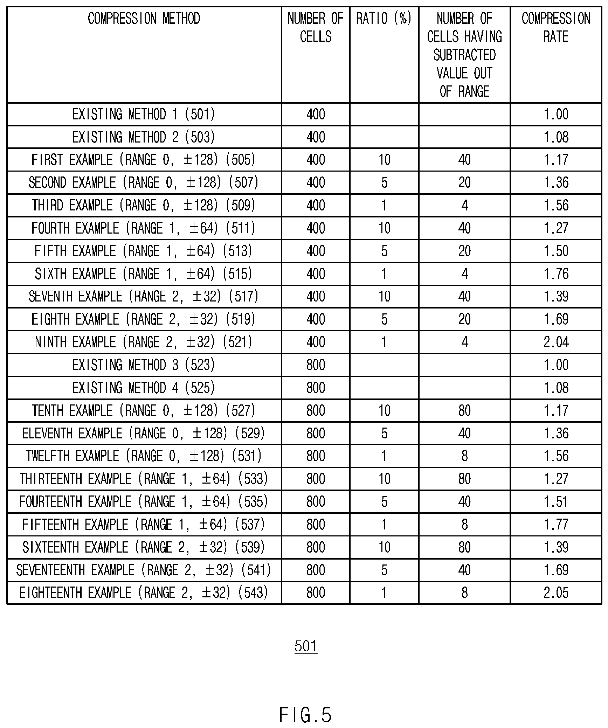

FIG. 5 illustrates examples of compression rates according to examples of a battery management device and a battery management method according to an embodiment of the present disclosure.

Referring to FIG. 5, a table may indicate compression rates according to examples. A compression method according to existing methods (e.g., an existing method 1 501, an existing method 2 503, an existing method 3 523, and an existing method 4 525) may indicate a method of generating a data stream according to values obtained by subtracting an offset value (a value corresponding to a representative value in an embodiment) from measured values. Since the values obtained by subtracting the offset value from the measured values are smaller in absolute value than the measured values, the number of bits required to generate the data stream after compression using the existing methods may be smaller than the number of bits required to generate the data stream before compression.

In the existing method 1 501, a data stream may be generated based on an offset value of 0 and battery data for about 400 battery cells. A compression rate of the existing method 1 501 may be approximately 1.00.

In the existing method 2 503, a data stream may be generated based on an offset value of 2000 and battery data for about 400 battery cells. A compression rate of the existing method 2 503 may be about 1.08.

In a first example 505, the data compression method according to an embodiment may perform data compression on measured values of about 400 battery cells, after determining a range (e.g., a range from -128 to +128) with a range identifier of 0 as a range in which data compression is to be performed. When the ratio of the number of battery cells (e.g., about 40) that are not included in any one range of battery cells to the total number of battery cells (e.g., about 400) is about 10%, the compression rate of the first example 505 may be about 1.17.

In a second example 507, the data compression method according to an embodiment may perform data compression on measured values of about 400 battery cells, after determining a range (e.g., -128 to +128) with a range identifier of 0 as a range in which data compression is to be performed. When the ratio of the number of battery cells (e.g., about 40) that are not included in any one range of battery cells to the total number of battery cells (e.g., about 400) is about 5%, the compression rate of the second example 507 may be about 1.36.

In a third example 509, the data compression method according to an embodiment may perform data compression on measured values of 400 battery cells, after determining a range (e.g., a range from -128 to +128) with a range identifier of 0 as a range in which data compression is to be performed. When the ratio of the number of battery cells (e.g., about 40) that are not included in any one range of battery cells to the total number of battery cells (e.g., about 400) is about 1%, the compression rate of the third example 509 may be about 1.56.

In a fourth example 511, the data compression method according to an embodiment may perform data compression on measured values of about 400 battery cells, after determining a range (e.g., a range from -64 to +64) with a range identifier of 1 as a range in which data compression is to be performed. When the ratio of the number of battery cells (e.g., about 20) that are not included in any one range of battery cells to the total number of battery cells (e.g., about 400) is about 5%, the compression rate of the fourth example 511 may be about 1.27.

In a fifth example 513, the data compression method according to an embodiment may perform data compression on measured values of about 400 battery cells, after determining a range (e.g., a range from -64 to +64) with a range identifier of 1 as a range in which data compression is to be performed. When the ratio of the number of battery cells (e.g., about 40) that are not included in any one range of battery cells to the total number of battery cells (e.g., about 400) is about 5%, the compression rate of the fifth example 513 may be about 1.50.

In a sixth example 515, a data compression method according to an embodiment may perform data compression after determining a range (e.g., a range from -64 to +64) with a range identifier of 1 as a range in which data compression is to be performed and determining the range (e.g., the range from -64 to +64) with the range identifier of 1 as the range in which data compression is to be performed for measured values of about 400 battery cells. When the ratio of the number of battery cells (e.g., about 4) that are not included in any one range of battery cells to the total number of battery cells (e.g., about 400) is about 1%, the compression rate of the sixth example 515 may be about 1.76.

In a seventh example 517, a data compression method according to an embodiment may perform data compression after determining a range (e.g., a range from -32 to +32) with a range identifier of 2 as a range in which data compression is to be performed and determining the range (e.g., the range from -32 to +32) with the range identifier of 2 as the range in which data compression is to be performed for measured values of about 400 battery cells. When the ratio of the number of battery cells (e.g., about 40) that are not included in any one range of battery cells to the total number of battery cells (e.g., about 400) is about 10%, the compression rate of the seventh example 517 may be about 1.39.

In an eighth example 519, the data compression method according to an embodiment may perform data compression on measured values of about 400 battery cells, after determining a range (e.g., a range from -32 to +32) with a range identifier of 2 as a range in which data compression is to be performed. When the ratio of the number of battery cells (e.g., about 20) that are not included in any one range of battery cells to the total number of battery cells (e.g., about 400) is about 5%, the compression rate of the eighth example 519 may be about 1.69.

In a ninth example 521, the data compression method according to an embodiment may perform data compression on measured values of about 400 battery cells, after determining a range (e.g., a range from -32 to +32) with a range identifier of 2 as a range in which data compression is to be performed. When the ratio of the number of battery cells (e.g., about 4) that are not included in any one range of battery cells to the total number of battery cells (e.g., about 400) is about 1%, the compression rate of the ninth example 521 may be about 2.04.

In the existing method 3 523, a data stream may be generated based on an offset value of 0 and battery data for about 800 battery cells. A compression rate of the existing method 3 523 may be about 1.00.

In the existing method 4 535, a data stream may be generated based on an offset value of 2000 and battery data for about 800 battery cells. A compression rate of the existing method 4 525 may be about 1.08.

In a tenth example 527, the data compression method according to an embodiment may perform data compression on measured values of about 800 battery cells, after determining a range (e.g., a range from -128 to +128) with a range identifier of 0 as a range in which data compression is to be performed. When the ratio of the number of battery cells (e.g., about 80) that are not included in any one range of battery cells to the total number of battery cells (e.g., about 800) is about 10%, the compression rate of the tenth example 527 may be about 1.17.

In an eleventh example 529, a data compression method according to an embodiment may perform data compression after determining a range (e.g., a range from -128 to +128) with a range identifier of 0 as a range in which data compression is to be performed and determining the range (e.g., the range from -128 to +128) with the range identifier of 0 as the range in which data compression is to be performed for measured values of about 800 battery cells. When the ratio of the number of battery cells (e.g., about 20) that are not included in any one range of battery cells to the total number of battery cells (e.g., about 800) is about 5%, the compression rate of the eleventh example 529 may be about 1.36.

In a twelfth example 531, the data compression method according to an embodiment may perform data compression on measured values of about 800 battery cells, after determining a range (e.g., a range from -128 to +128) with a range identifier of 0 as a range in which data compression is to be performed. When the ratio of the number of battery cells (e.g., about 8) that are not included in any one range of battery cells to the total number of battery cells (e.g., about 800) is about 1%, the compression rate of the twelfth example 531 may be about 1.56.

In a thirteenth example 533, a data compression method according to an embodiment may perform data compression after determining a range (e.g., a range from -68 to +68) with a range identifier of 1 as a range in which data compression is to be performed and determining the range (e.g., the range from -68 to +68) with the range identifier of 1 as the range in which data compression is to be performed for measured values of about 800 battery cells. When the ratio of the number of battery cells (e.g., about 8) that are not included in any one range of battery cells to the total number of battery cells (e.g., about 800) is about 10%, the compression rate of the thirteenth example 533 may be about 1.27.

In a fourteenth example 535, the data compression method according to an embodiment may perform data compression on measured values of about 800 battery cells, after determining a range (e.g., a range from -68 to +68) with a range identifier of 1 as a range in which data compression is to be performed. When the ratio of the number of battery cells (e.g., about 20) that are not included in any one range of battery cells to the total number of battery cells (e.g., about 800) is about 5%, the compression rate of the fourteenth example 535 may be about 1.51.

In a fifth example 537, the data compression method according to an embodiment may perform data compression on measured values of about 800 battery cells, after determining a range (e.g., a range from -68 to +68) with a range identifier of 1 as a range in which data compression is to be performed. When the ratio of the number of battery cells (e.g., about 8) that are not included in any one range of battery cells to the total number of battery cells (e.g., about 800) is about 8%, the compression rate of the fifteenth example 537 may be about 1.77.

In a sixteenth example 539, the data compression method according to an embodiment may perform data compression on measured values of about 800 battery cells, after determining a range (e.g., a range from -32 to +32) with a range identifier of 2 as a range in which data compression is to be performed. When the ratio of the number of battery cells (e.g., about 80) that are not included in any one range of battery cells to the total number of battery cells (e.g., about 800) is about 10%, the compression rate of the sixteenth example 539 may be about 1.39.

In a seventeenth example 541, the data compression method according to an embodiment may perform data compression on measured values of about 800 battery cells, after determining a range (e.g., a range from -32 to +32) with a range identifier of 2 as a range in which data compression is to be performed. When the ratio of the number of battery cells (e.g., about 20) that are not included in any one range of battery cells to the total number of battery cells (e.g., about 800) is about 5%, the compression rate of the seventeenth example 541 may be about 1.69.

In an eighteenth example 543, the data compression method according to an embodiment may perform data compression on measured values of about 800 battery cells, after determining a range (e.g., a range from -32 to +32) with a range identifier of 2 as a range in which data compression is to be performed. When the ratio of the number of battery cells (e.g., about 8) that are not included in any one range of battery cells to the total number of battery cells (e.g., about 800) is about 1%, the compression rate of the eighteenth example 543 may be about 2.05.

According to an embodiment, the compression rate of the compression method according to an embodiment may be greater than the compression rate of the compression method according to the method in the related art.

According to an embodiment, the compression rate may be increased as the range in which data compression is to be performed is narrowed.

According to an embodiment, the compression rate may be increased as the ratio of the number of battery cells corresponding to subtracted values not included in any one range of battery cells to the total number of battery cells decreases.

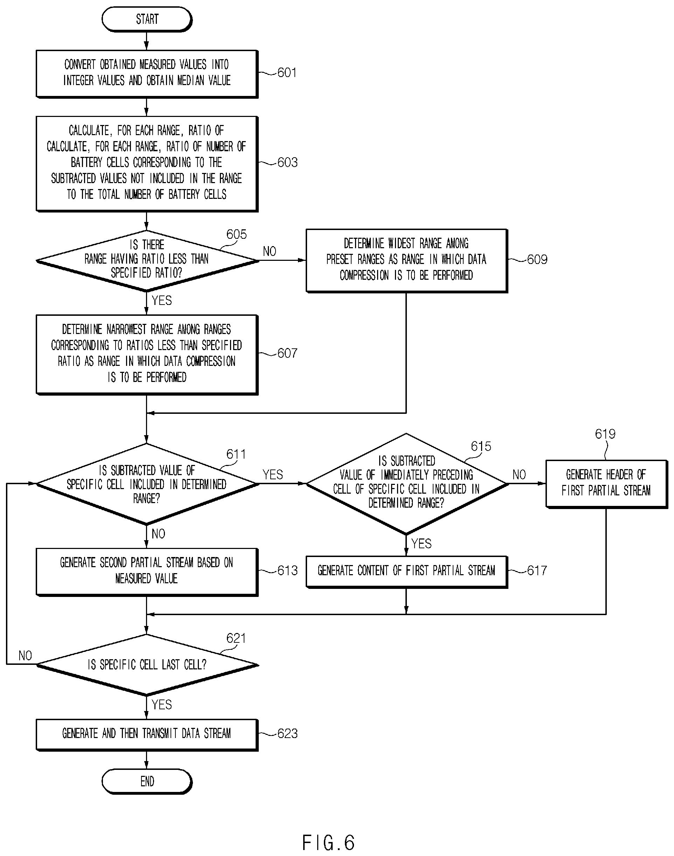

FIG. 6 illustrates an example of a flow of operations of a battery management device that generates a data stream through a first partial stream and a second partial stream, in the battery management device and a battery management method according to an embodiment of the present disclosure.

Referring to FIG. 6, in first operation 601, the one or more processors 205 according to an embodiment may convert obtained measured values into integer values and obtain a median value.

According to an embodiment, the obtained measured values may include voltage values of the battery cells expressed in decimal form. The one or more processors 205 may represent voltage values expressed in decimal form as integers by changing the units of the measured values.

In second operation 603, the one or more processors 205 according to an embodiment may calculate, for each range, the ratio of the number of battery cells corresponding to the subtracted values not included in the range to the total number of battery cells.

According to an embodiment, the one or more processors 205 may calculate a ratio for each of the ranges in which preset data compression is to be performed.

For example, the first range may indicate a range from -128 to +128. The second range may indicate a range from -64 to +64. The third range may indicate a range from -32 to +32.

According to an embodiment, the one or more processors 205 may calculate a ratio of a number of battery cells corresponding to subtracted values not included in a range (e.g., the first range, the second range, or the third range) to the total number of battery cells.

In third operation 605, the one or more processors 205 according to an embodiment may identify whether there is a range having a ratio less than a specified ratio. When there is a range having the ratio less than the specified ratio, the one or more processors 205 may perform fourth operation 607. When there is no range having the ratio less than the specified ratio, the one or more processors 205 may perform fifth operation 609.

According to an embodiment, the one or more processors 205 may identify whether, among the ratios (e.g., about 5%, about 9%, and about 20%) according to the ranges (e.g., the first range, the second range, and the third range), there is a range having a ratio less than a specified ratio (e.g., about 10%). This is because the narrower the range in which data compression is to be performed, the higher the compression rate may be.

In fourth operation 607, the one or more processors 205 according to an embodiment may determine the narrowest range among the ranges corresponding to ratios less than the specified ratio as the range in which data compression is to be performed.

According to an embodiment, the one or more processors 205 may determine the narrowest range (e.g., the second range) among ranges (e.g., the first range corresponding to the ratio of about 5% and the second range corresponding to the ratio of about 9%) corresponding to ratios less than the specified ratio (e.g., about 10%) as the range in which data compression is to be performed. This is because the narrower the range in which data compression is performed, the higher the data compression rate may be.

In fifth operation 609, the one or more processors 205 according to an embodiment may determine the widest range among the preset ranges as the range in which data compression is to be performed.

This is because, as the range in which data compression is to be performed becomes wider, the ratio becomes smaller, and as the ratio of the number of battery cells corresponding to the subtracted values that are not included in any one range of battery cells to the total number of battery cells becomes smaller, the compression rate may become higher.

In sixth operation 611, the one or more processors 205 according to an embodiment may identify whether a subtracted value of a specific cell is included in the determined range. When the subtracted value of the specific cell is included in the determined range, the one or more processors 205 may perform seventh operation 613. When the subtracted value of the specific cell is not included in the determined range, the one or more processors 205 may perform eighth operation 615.

In seventh operation 613, the one or more processors 205 according to an embodiment may generate the second partial stream based on the measured value.

In eighth operation 615, the one or more processors 205 according to an embodiment may identify whether a subtracted value of an immediately preceding cell of the specific cell is included in the determined range. When the subtracted value of the immediately preceding cell of the specific cell is within the determined range, the one or more processors 205 may perform ninth operation 617. When the subtracted value of the immediately preceding cell of the specific cell is not included in the determined range, tenth operation 619 may be performed.

In ninth operation 617, the one or more processors 205 according to an embodiment may generate the content of the first partial stream.

In tenth operation 619, the one or more processors 205 according to an embodiment may generate a header of the first partial stream.

In eleventh operation 621, the one or more processors 205 according to an embodiment may identify whether the specific cell is the last cell. When the specific cell is the last cell, the one or more processors 205 according to an embodiment may perform twelfth operation 623. When the specific cell is not the last cell, the one or more processors 205 according to an embodiment may perform sixth operation 611.

In twelfth operation 623, the one or more processors 205 according to an embodiment may generate and then transmit a data stream.

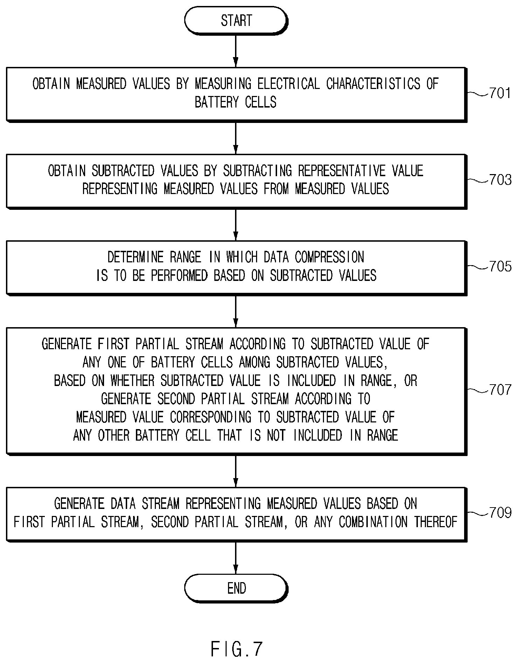

FIG. 7 illustrates an example of a flow of operations of a battery management device that generates a data stream through at least one of a first partial stream, a second partial stream, or any combination thereof, in the battery management device and a battery management method according to an embodiment of the present disclosure.

Referring to FIG. 7, in first operation 701, the one or more processors 205 according to an embodiment may obtain measured values by measuring electrical characteristics of battery cells.

In second operation 703, the one or more processors 205 according to an embodiment may obtain subtracted values by subtracting representative value representing measured values from measured values.

In third operation 705, the one or more processors 205 according to an embodiment may determine a range in which data compression is to be performed based on the subtracted values.

In fourth operation 707, the one or more processors 205 according to an embodiment may generate a first partial stream according to a subtracted value of any one of the battery cells, based on whether the subtracted value of the one battery cell among the subtracted values is included in the range, or may generate a second partial stream according to a measured value corresponding to a subtracted value of any other battery cell that is not included in the range.

In fifth operation 709, the one or more processors 205 according to an embodiment may generate a data stream representing the measured values based on at least one of the first partial stream, the second partial stream, or any combination thereof.

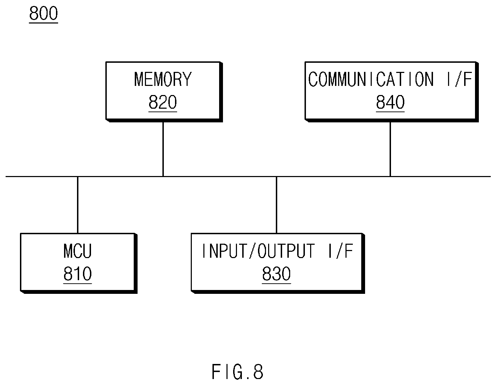

FIG. 8 is a block diagram illustrating a hardware configuration of a computing system for performing a battery management method in a battery management device and the battery management method according to an embodiment of the present disclosure.

Referring to FIG. 8, a computing system 800 according to an embodiment disclosed herein may include a microcontroller unit (MCU) 810, a memory 820, an input/output interface (I/F) 830, and a communication I/F 840.

The MCU 810 may be one or more processors that execute various programs (e.g., a battery cell data collection program, a graph generation program, a data analysis program, a data decomposition algorithm, a normalization program, a battery cell diagnosis program, and the like) stored in the memory 820, process various pieces of information including battery cell characteristic data, latent variables, and the like through the programs, and perform functions of the battery management device 201 shown in the above-described FIGS. 1 to 8.

The memory 820 may store various programs such as the battery cell data collection program, the graph generation program, the data analysis program, the data decomposition algorithm, the normalization program, the battery cell diagnosis program, and the like.

A plurality of memories 820 may be provided as needed. The memory 820 may be a volatile memory or non-volatile memory. As the volatile memory, the memory 820 may be a random-access memory (RAM), dynamic RAM (DRAM), static RAM (SRAM), or the like. As the nonvolatile memory, for the memory 820, a read-only memory (ROM), a programmable ROM (PROM), an electrically alterable ROM (EAROM), an erasable programmable ROM (EPROM), an electrically erasable programmable ROM (EEPROM), a flash memory, or the like. The examples of memories 820 listed above are only exemplary and are not limited to the examples.

The input/output I/F 830 may provide an interface that enables data to be transmitted and received by connecting an input device (not illustrated) such as a keyboard, mouse, or touch panel, and an output device (not illustrated) such as a display and the MCU 810.

The communication I/F 840 is a component capable of transmitting and receiving various data with a server, and may be any device capable of supporting wired or wireless communication. For example, the battery management device 201 may transmit and receive various types of information, including a shape model of a battery cell or the like, to and from a separately provided external server through the communication I/F 840.

By being recorded in the memory 820 and processed by the MCU 810 in this way, a computer program according to an embodiment disclosed herein may be implemented, for example, as a module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The foregoing disclosure outlines features of several embodiments so that those skilled in the art may better understand the aspects of the present disclosure. Those skilled in the art will appreciate that the present disclosure may readily serve as a basis for designing or modifying other structures for carrying out the same purposes or achieving the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

## Claims

1. A battery management device, comprising:
a memory configured to store at least one instruction; and
one or more processors configured to execute the at least one instruction,
wherein the one or more processors are configured to:
obtain measured values by measuring electrical characteristics of battery cells;
obtain subtracted values by subtracting a representative value representing the measured values from the measured values;
determine a range in which data compression is to be performed based on the subtracted values;
generate a first partial stream according to a subtracted value of any one of the battery cells among the subtracted values, or generate a second partial stream according to a measured value corresponding to the subtracted value, based on whether the subtracted value is included in the range; and
generate a data stream indicating the measured values based on at least one of the first partial stream, the second partial stream, or any combination thereof.

2. The battery management device of claim 1, wherein the one or more processors are configured to identify the representative value as a median value.

3. The battery management device of claim 1, wherein the one or more processors are configured to generate a header of the data stream to include at least one of a stream indicating the range, a stream indicating the representative value, or any combination thereof.

4. The battery management device of claim 1, wherein the one or more processors are configured to, when the subtracted value of the one battery cell among the subtracted values is included in the range, generate the first partial stream to include at least one of a stream indicating a fact that the subtracted value of the one battery cell is included in the range, a stream indicating the subtracted value of the one battery cell, or any combination thereof.

5. The battery management device of claim 1, wherein the one or more processors are configured to, when a subtracted value of any other one of the battery cells among the subtracted values is not included in the range, generate the second partial stream to include at least one of a stream indicating a fact that the subtracted value of the other battery cell is not included in the range, a stream indicating a measured value of the other battery cell, or any combination thereof.

6. The battery management device of claim 1, wherein the one or more processors are configured to, when the battery cells corresponding to the subtracted values included in the range are consecutive according to a specified order of the battery cells:
generate a header of the first partial stream to include a stream indicating a fact that the battery cells corresponding to the subtracted values included in the range are consecutive, and a stream indicating the number of the consecutive battery cells; and
generate the first partial stream to sequentially represent subtracted values of the consecutive battery cells according to the specified order.

7. The battery management device of claim 1, wherein the one or more processors are configured to, in order to determine the range from among preset ranges in which data compression is to be performed:
identify, according to any one of the ranges, a ratio of the number of battery cells corresponding to subtracted values not included in the one range of the ranges to the total number of the battery cells; and
determine, as the range, the narrowest range among the ranges having the ratio less than a specified ratio.

8. The battery management device of claim 7, wherein the one or more processors are configured to determine the widest range among the preset ranges as the range when there is no range having a ratio less than the specified ratio among the ranges.

9. The battery management device of claim 1, wherein the measured values obtained by measuring electrical characteristics include values obtained by measuring voltages of the battery cells.

10. A method of managing a battery, comprising:
obtaining measured values by measuring electrical characteristics of battery cells;
obtaining subtracted values by subtracting a representative value representing the measured values from the measured values;
determining a range in which data compression is to be performed based on the subtracted values;
generating a first partial stream according to a subtracted value of any one of the battery cells among the subtracted values or generating a second partial stream according to a measured value corresponding to the subtracted value, based on whether the subtracted value is included in the range; and
generating a data stream indicating the measured values based on at least one of the first partial stream, the second partial stream, or any combination thereof.

11. The method of claim 10, wherein the obtaining of the subtracted values by subtracting the representative value representing the measured values from the measured values includes identifying the representative value as a median value.

12. The method of claim 10, wherein the generating of the data stream indicating the measured values based on at least one of the first partial stream, the second partial stream, or any combination thereof includes generating a header of the data stream to include at least one of a stream indicating the range, a stream indicating the representative value, or any combination thereof.

13. The method of claim 10, wherein the generating of the first partial stream according to a subtracted value of any one of the battery cells among the subtracted values or generating of the second partial stream according to a measured value corresponding to the subtracted value, based on whether the subtracted value is included in the range includes generating, when the subtracted value of the one battery cell among the subtracted values is included in the range, the first partial stream to include at least one of a stream indicating a fact that the subtracted value of the one battery cell is included in the range, a stream indicating the subtracted value of the one battery cell, or any combination thereof.

14. The method of claim 10, wherein the generating of the first partial stream according to a subtracted value of any one of the battery cells among the subtracted values or generating of the second partial stream according to a measured value corresponding to the subtracted value, based on whether the subtracted value is included in the range includes generating, when a subtracted value of any other one of the battery cells among the subtracted values is not included in the range, the second partial stream to include at least one of a stream indicating a fact that the subtracted value of the other battery cell is not included in the range, a stream indicating a measured value of the other battery cell, or any combination thereof.

15. The method of claim 10, wherein the generating of the first partial stream according to a subtracted value of any one of the battery cells among the subtracted values or generating of the second partial stream according to a measured value corresponding to the subtracted value, based on whether the subtracted value is included in the range includes, when the battery cells corresponding to the subtracted values included in the range are consecutive according to a specified order of the battery cells:
generating a header of the first partial stream to include a stream indicating a fact that the battery cells corresponding to the subtracted values included in the range are consecutive, and a stream indicating the number of the consecutive battery cells; and
generating the first partial stream to sequentially represent subtracted values of the consecutive battery cells according to the specified order.

16. The method of claim 10, wherein the determining of the range in which data compression is to be performed based on the subtracted values includes, in order to determine the range from among preset ranges in which data compression is to be performed:
identifying, according to any one of the ranges, a ratio of the number of battery cells corresponding to subtracted values not included in the one range of the ranges to the total number of the battery cells; and
determining, as the range, the narrowest range among the ranges having the ratio less than a specified ratio.

17. The method of claim 16, wherein the determining of the range in which data compression is to be performed based on the subtracted values includes determining the widest range among the preset ranges as the range when there is no range having a ratio less than the specified ratio among the ranges.

18. The method of claim 10, wherein the measured values obtained by measuring electrical characteristics include values obtained by measuring voltages of the battery cells.
